# NEUE EUROPÄISCHE PATENTSCHRIFT

(11) **EP 2 489 956 B2**
(45) Veröffentlichungstag und Bekanntmachung des Hinweises auf die Entscheidung über den Einspruch: **09.09.2020**
(45) Hinweis auf die Patenterteilung: 05.04.2017
(21) Anmeldenummer: 11155224.6
(22) Anmeldetag: 21.02.2011
(51) Int. Cl.: F24H 9/00, F24H 9/20, H01L 23/32, H01L 23/40

(54) **Kühleinrichtung eines elektrischen, sich erwärmenden Bauelements**
Cooling system of an electric construction element that heats up
Dispositif de refroidissement d'un composant électrique se chauffant

(43) Veröffentlichungstag der Anmeldung: 22.08.2012
(73) Patentinhaber: Gerdes Holding GmbH & Co. KG, 21337 Lüneburg (DE)
(72) Erfinder: Beck, Klaus, 22946 Trittau (DE); Koch, Christian, 21403 Wendisch Evern (DE)
(74) Vertreter: Stork Bamberger Patentanwälte PartmbB

(56) Entgegenhaltungen:
- EP-A1- 2 226 590
- EP-A2- 2 455 680
- DE-A1- 2 728 564
- DE-A1- 2 728 564
- DE-A1- 3 123 036
- DE-A1- 3 143 336
- DE-A1- 19 806 017
- US-A- 4 756 081
- US-A- 5 483 103
- US-A- 6 055 154
- US-A1- 2001 008 046
- US-B1- 6 892 796

## Beschreibung

Die Erfindung betrifft eine Kühleinrichtung eines elektronischen, sich erwärmenden Bauelements, umfassend das eine Wärmeleitfläche zur Wärmeabführung sowie elektrische Anschlusspins aufweisende elektronische Bauelement, eine zwei einander gegenüberliegende Flächenseiten aufweisende elektrische Leiterplatte mit Anschlussstellen, mit denen die elektrischen Anschlusspins verbunden sind, ein thermisches Kühlelement mit einer Kühlfläche, die an der Wärmeleitfläche anliegt, und einen Lagerkörper, an dem die Leiterplatte gelagert ist. Das elektronische Bauelement ist insbesondere ein elektronisches Leistungsschaltelement mit Halbleiterschichtstruktur, z.B. in Form von Thyristoren, Leistungstransistoren oder Triacs. Es weist beinchenförmige Anschlusspins auf, mittels derer es auf eine Leiterplatte zum Beispiel in Form einer Leiterkarte, Platine oder gedruckten Schaltung üblicherweise aufgelötet ist.

Eine Wärme abgebende Wärmeleitfläche des Bauelements muss an eine Wärme abführende Kühlfläche gepresst werden, um Erwärmung im Betrieb des Bauelements zu begrenzen und so dessen Funktion sicherzustellen. Es sind zahlreiche unterschiedliche Kühleinrichtungen bekannt.

Aus DE 27 28 564 A1 ist eine Kühleinrichtung in Verbindung mit Halbleiterelementen bekannt, die in thermischem Kontakt mit einem wärmeleitenden Boden eines Gehäuses (Lagerkörpers) stehen. Eine für jedes Halbleiterelement vorgesehene Klemmeinrichtung der Kühleinrichtung umfasst einen Klemmverbund, in dem sich der Reihe nach eine wärmeleitende Schicht, ein metallener Kontaktstreifen, ein sich erwärmendes Halbleiterelement, ein metallenes Druckstück, eine Zuführungselektrode und ein Isolierstück befinden, wobei diese Teile klemmend zwischen eine Klemmfläche des wärmeleitenden Gehäusebodens und eine Klemmfläche einer an dem Gehäuse angeordneten Feder eingefügt sind. Der Kontaktstreifen sowie die Zuführungselektrode sind mit elektrischen Zuleitungen verbunden, die aus dem Gehäuse zum Anschluss zum Beispiel an eine elektrische Leiterplatte herausgeführt sind, die nur außerhalb des Gehäuses und der Reihe der geklemmten Teile angeordnet werden kann. Das Gehäuse bildet das mehrere genannte Halbleiterelemente aufnehmende Gehäuse eines für sich selbstständigen Halbleiterbauelements.

Eine häufig genutzte Anordnung zur Kühlung besteht darin, dass ein Leistungsschalter mit seiner Wärmeleitfläche an einer Leiterplatte aufrecht ausgerichtet wird und die Wärmeleitfläche seitlich an ein Kühlmedium, zum Beispiel an Kühlflächen bildende Kupfer- oder Messingteile angelegt wird. Zum Beispiel werden in einem elektronischen Wasser-Durchlauferhitzer Leistungsschalter einer Leistungselektronik zur Kühlung direkt an einem Wasserleitungsrohr angebracht (DE 20 2004 012 263, Fig. 5). In solchen Anordnungen zur Kühlung bleibt die Wärmeabfuhr unbefriedigend. Eine plane Anlage aneinanderliegender thermischer Flächen ist nur bedingt herstellbar. Die angestrebte plane Anlage wird insbesondere dadurch beeinträchtigt, dass, insbesondere bei Serienfertigung, Oberflächen- oder Konturtoleranzen des Leistungsschalters und/oder anderer an zugehöriger Bestückung beteiligter Bauelemente, insbesondere wenn die Bauelemente von unterschiedlichen Herstellern bezogen werden, zu thermischen Wärmeübergang behindernder Fehlanpassung führen. Man behilft sich zumeist mit unmittelbar an dem Kühlelement und dem Bauelement angebrachten, Klemmkraft erzeugenden Klammermitteln.

Abgesehen davon, dass mit solchen Maßnahmen zusätzlich Aufwand und Handhabung verbunden sind, steht häufig auch kein ausreichender Montageraum zur Verfügung. Weiterhin bleibt zu berücksichtigen, dass die Anschlussbeinchen (Anschlusspins) der elektronischen Leistungsschalter oder dergleichen Bauelemente eine relativ geringe Länge aufweisen und nur sehr eingeschränkt mechanischer Belastung standhalten können. Mechanische Belastung in herkömmlicher Klammer- und/oder Schraubverbindung führt bisweilen dazu, dass Lötverbindungen von Anschlusspins an den Anschlussstellen von vornherein fehlerhaft sind oder sich später lösen. Die genannten Bauteiltoleranzen begünstigen derartige nachteilige Effekte.

Der Erfindung liegen die Ziele zugrunde, die Kühleinrichtung hinsichtlich zuverlässig wirksamer Kühlung, kompakter Bauform und -größe, der Beseitigung von mechanischen Einflüssen, insbesondere durch körperliche Toleranzabweichung baugleicher elektronischer Bauelemente, und Montagefreundlichkeit zu verbessern.

Die Ziele werden mit den Merkmalen des Anspruchs 1 erreicht.

Mit der erfindungsgemäßen, die Kühleinrichtung bildenden Anordnung der Konstruktions- bzw. Bauteile erreicht man mehrere Vorteile. Die an dem Lagerkörper vorgesehenen Klemmflächen bilden ein oder mehrere definierte Klemmflächenpaare, zwischen denen jeweils ein Klemmverbund eingespannt ist, in dem wenigstens ein elektronisches Bauelement an das zugehörige Kühlelement unter planer bzw. flächiger Anlage der Wärmeleitfläche des Bauelements an der Kühlfläche des Kühlelements gepresst ist. Die in ihrer räumlichen Relation zueinander definierten Klemmflächen bestimmen die Lage des Klemmverbundes. Die Leiterplatte erstreckt sich zwischen den Klemmflächen jedes Klemmflächenpaares hindurch, wobei die Lage des elektronischen Bauelements in Bezug auf die Klemmplatte definiert ist. Klemm-/Spannkräfte auf den Klemmverbund werden weder über den Verbund, noch über die Leiterplatte auf die Anschlusspins oder Anschlussstellen übertragen. Die erfindungsgemäßen Maßnahmen führen dazu, dass Bauteil- bzw. Konturtoleranzen und auch Dimensionsunterschieden der elektronischen Bauteile ohne Beeinträchtigung der Kühlverbindung entsprochen werden kann. Klemmkräfte können definiert und reproduzierbar aufgebracht und eingestellt werden.

Eine besonders bevorzugte Gestaltung besteht darin, dass der Klemmverbund durch das Kühlelement, einen Klemmhalter und, in Klemmanordnung zwischen dem Kühlelement und dem Klemmhalter, wenigstens das eine elektronische Bauelement gebildet ist. Der Klemmhalter bildet ein Element, an dem sich das elektronische Bauelement auf seiner der ersten Klemmfläche zugewandten Seite in formschlüssigem Sitz befindet. Die der ersten Klemmfläche zugeordnete Kopfseite des Klemmverbundes wird durch den Klemmhalter gebildet. Die Gestaltung kann dann zweckmäßig derart sein, dass der Klemmhalter an der Kopfseite des Klemmverbundes eine der Leiterplatte zugewandte Kopffläche aufweist, an der wenigstens ein von der Kopffläche hervorragender, die Durchgriffsausnehmung durchgreifender, in Klemmanlage an der ersten Klemmfläche befindlicher Vorsprung ausgebildet ist. Vorsprung und Durchgriffsausnehmung können in formschlüssige Anpassung aufeinander so dimensioniert sein, dass dadurch eine Justierhilfe zum Anbringen des Klemmhalters ausgebildet ist.

Eine Ausgestaltung besteht darin, dass der Klemmhalter einen den Anschlusspins zugeordneten Formrand aufweist, an dem die Anschlusspins unter Ausbildung definierter Knicklänge und Ausrichtung zu den Anschlussstellen der Leiterplatte abgebogen sind.

An dem Formrand des Klemmhalters können Ausnehmungen ausgebildet sein, die die Anschlusspins aufnehmen, um Kriechströmen zwischen den Anschlusspins in besonderem Maß entgegenzuwirken. Der Klemmhalter, der vorteilhaft aus Kunststoff gefertigt ist, bildet ein Distanzstück, das das elektronische Bauelement zu der ersten Klemmfläche definiert beabstandet. Es bildet zugleich eine Justier- und Montagehilfe zum Anbringen des elektronischen Bauelements, wenn dessen Anschlusspins, wie üblich, an die Anschlussstellen angelötet werden. Vorteilhaft wird der Klemmhalter zwischen der Leiterplatte und den an den Anschlussstellen der Leiterplatten befestigten Anschlusspins gefangengehalten. Zweckmäßig kann es sein, dass sich wenigstens zwei elektronische Bauelemente jeweils im Klemmverbund mit ein und demselben Klemmhalter befinden.

Eine besonders raumsparende Anordnung besteht darin, dass die Leiterplatte eine Ausnehmung aufweist, durch die wenigstens ein Verbindungselement hindurchfasst, dass die erste Klemmfläche mit dem Lagerkörper verbindet. Zweckmäßig ist wenigstens ein Verbindungselement Bestandteil einer Schraubverbindung. Die Schraubverbindung besteht besonders vorteilhaft aus einem die genannte Ausnehmung der Leiterplatte frei durchfassenden Sockel und einer darin eingedrehten zugehörigen Klemmschraube. Statt einer Schrauverbindung können andere Verbindungen zur Montage bzw. zum Fixieren der Klemmfläche an dem Lagerkörper vorgesehen werden.

Vorteilhaft ist die erste Klemmfläche, d. h. wenigstens eine erste Klemmfläche oder jede erste Klemmfläche durch einen Klemmarm oder ein als Klemmarm wirkendes Teil gebildet. Vorzugsweise wird zur Ausbildung wenigstens eines Klemmarms ein Plattenelement od. dgl. Element insbesondere mittels Schraubverbindung an dem Lagerkörper montiert. Vorteilhaft ist es auch, dass mehrere erste Klemmflächen durch wenigstens zwei Klemmarme, zum Beispiel durch einen mittels Klemmplatte gebildeten Doppelarm gebildet sein können, die mittels gemeinsamer Verbindung an dem Lagerkörper angeordnet und befestigt sind.

Als Kühlelement kann jeder zur thermischen Wärmeableitung geeigneter Körper, zum Beispiel aus Kupfer-, Messing-, Keramikmaterial od. dgl., vorgesehen werden, der, zum Beispiel mittels Lamellen oder Rippen, Wärme an ein Kühlmedium oder einen weiteren Kühlkörper abgibt. Die erfindungsgemäße Gestaltung besteht darin, dass das Kühlelement einen zur Wärmeabgabe an Flüssigkeit ausgebildeten, frei in diese eintauchbaren Kühlfuß sowie ein Stützelement zur Klemmanlage gegen die zweite Klemmfläche aufweist. Ein derartiges Kühlelement lässt sich in Verbindung mit weiteren ausgestaltenden Maßnahmen zur weiteren Verbesserung des kühlenden Wärmeübergangs nutzen. Für diese Gestaltung sieht die Erfindung vor, dass der Lagerkörper einen zum Führen von unter Druck stehender Flüssigkeit eingerichteten Flüssigkeitskanal und einen in den Flüssigkeitskanal mündenden Schacht umfasst, der den Kühlfuß im gegen Flüssigkeitsdurchtritt gedichteten Sitz aufnimmt, wobei ein zur Wärmeabgabe ausgebildetes Fußende des Kühlfußes in den Flüssigkeitskanal hineinragt. Zweckmäßig kann die erste Klemmfläche ein insbesondere federelastisch wirkender Klemmarm sein. Die Gestaltung kann derart sein, dass das Kühlelement bei klemmender Anlageposition an der zweiten Klemmfläche zur Übertragung von zusätzlicher Klemmkraft, gerichtet gegen mittels der ersten Klemmfläche wirkende Klemmkraft bzw. federelastische Rückstellkraft, frei bzw. ausweichlich gehalten ist. Man erreicht, dass das elektronische Bauelement, dass sich im Klemmverbund zwischen erster Klemmfläche und zweiter Klemmfläche befindet, zusätzlich mittels Druckkraft, die über die Flüssigkeit auf das Kühlelement ausgeübt wird, zur Kühlung angepresst wird. Eine solche Kühlanordnung ist von besonderem Vorteil in einem elektronischen gesteuerten Warmwassergerät, nämlich einem Durchlauferhitzer mit elektrischer Heizeinrichtung zum Erwärmen von durch den Durchlauferhitzer fließendem Wasser. Die Heizeinrichtung weist wenigstens ein zu kühlendes elektronisches Bauelement als Leistungsschalter auf, das zum Regeln der Warmwassertemperatur mit einer Leistungselektronik ansteuerbar ist, und eine Kühleinrichtung zum Kühlen des Leistungsschalters. Wenigstens ein Kühlelement der Kühleinrichtung steht in thermischer Verbindung mit einer Wärmeleitfläche des Leistungsschalters und gibt Wärme an mittels der Heizeinrichtung zu erwärmendes Wasser ab.

Um insbesondere die Montage von in ihrer Dimension Abweichungen aufweisenden elektronischen Bauelementen an übereinstimmend ausgebildeten Montagestellen zu erleichtern und die genannten Vorteile der Kühlanpressung zu erhalten, sieht die Erfindung vor, dass die Leiterplatte im Anordnungsbereich des elektronischen Bauelements von mechanischer Befestigung mit dem Lagerkörper frei ist. Insbesondere in Verbindung mit dieser Maßnahme ist es von besonderem Vorteil, wenn der Lagerkörper in der Umgebung bzw. in dem Anordnungsbereich des elektronischen Bauelements wenigstens ein Führungselement aufweist, das eine zu den Flächenseiten der Leiterplatte senkrechte Führung zur zumindest im Wesentlichen mit den Flächenseiten flächenparallelen Führungspositionierung der Leiterplatte bildet.

Auf die genannten und noch andere zweckmäßige und vorteilhafte Ausgestaltungen der Erfindung sind Unteransprüche gerichtet. Merkmale von Ausgestaltungen tragen in jeder Kombination zur erfindungsgemäßen Lösung bei, so dass diese nicht auf ein konkret beschriebenes Ausführungsbeispiel eingeschränkt ist. Lediglich besonders zweckmäßige und vorteilhafte Ausbildungsformen und -möglichkeiten der Erfindung werden anhand der folgenden Beschreibung der in der schematischen Zeichnung dargestellten Ausführungsbeispiele näher beschrieben. Es zeigen
- Fig. 1: in axonometrischer Ansicht im Teilausschnitt eine erfindungsgemäße Kühleinrichtung,
- Fig. 2: in Schnittansicht II-II die Kühleinrichtung gemäß Fig. 1,
- Fig. 3: in Ansicht der Schnittebene III-III die Kühleinrichtung in Fig. 2 und
- Fig. 4: in Detailansicht ein Kühlelement in Anordnung mit einem Kühlwasserkanal.

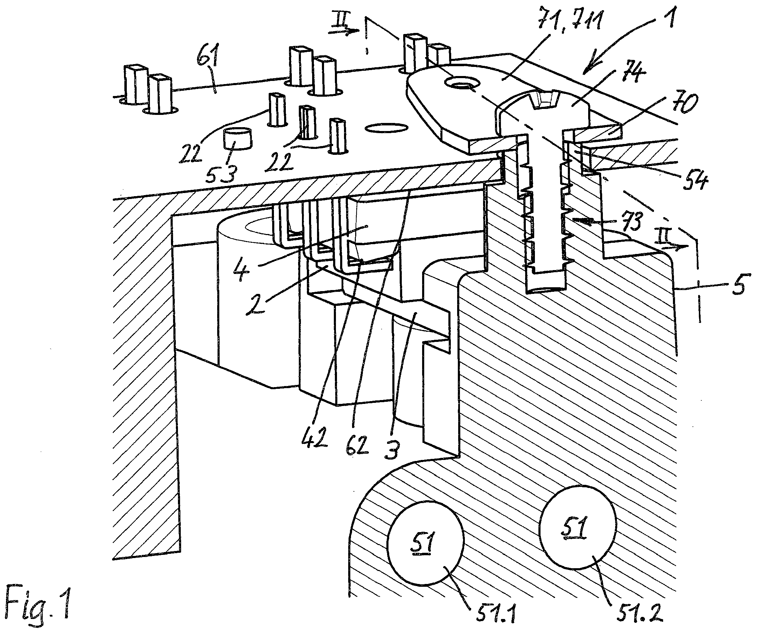

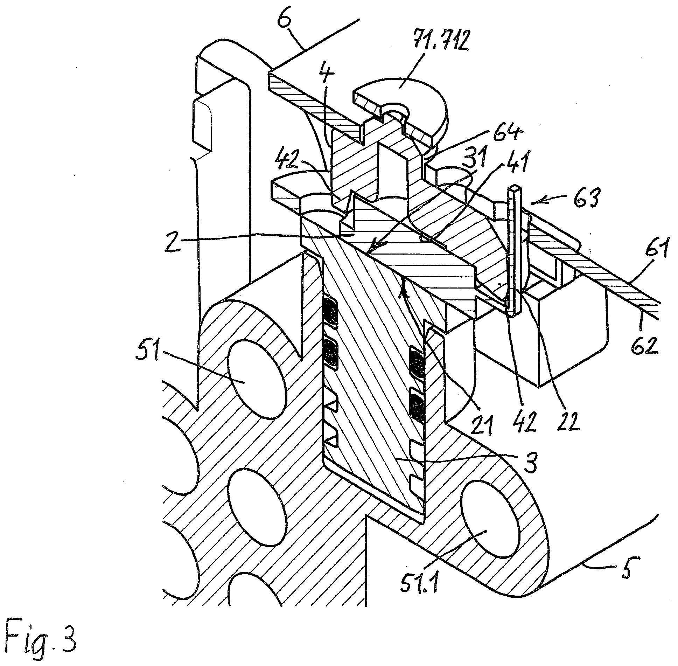

Eine in Fig. 1 bis 4 dargestellte erfindungsgemäße Kühleinrichtung 1 umfasst ein elektronisches Bauelement 2, im Ausführungsbeispiel einen Triac-Leistungsschalter, eine elektrische Leiterplatte 6, thermische Kühlelemente 3 und einen Lagerkörper 5. Bestandteile einer Klemmeinrichtung 7 sind erste Klemmflächen 71, gebildet durch eine Klemmplatte 70 und zweite Klemmflächen 72 sowie eine Schraubverbindung 73, mittels der die Klemmplatte 70 an dem Lagerkörper 5 angeordnet ist.

Die Klemmeinrichtung 7 umfasst einen doppelt vorgesehenen Klemmverbund 8. Dieser bildet jeweils eine Anordnungshälfte der Kühleinrichtung 1. Der Klemmverbund 8 ist dreiteilig ausgebildet, und zwar mit dem Kühlelement 3 in Form eines im Profilquerschnitt T-förmigen Kühlnippels aus wärmeleitendem Material, dem Bauelement 2 und einem Klemmhalter 4.

Das Kühlelement 3 weist einen Kühlfuß 32 mit Kühlrippen 320 sowie ein durch eine Kopfplatte gebildetes Stützelement 33 auf, das das Kühlelement 3 innerhalb des Lagerkörpers 5 gegen die Klemmflächen 72 lagert. Eine plane Kopffläche des Stützelements 33 bildet eine Kühlfläche 31 des Kühlelements 3.

Das Bauelement 2 weist zur Wärmeabführung eine plane Wärmeleitfläche 21 auf, mit der es im Klemmverbund 8 plan und damit flächig an der Kühlfläche 31 anliegt. Das Stützelement 33 des Kühlelements 3 bildet eine Fußseite des Klemmverbunds 8. Eine Kopfseite des Klemmverbunds 8 ist durch den Klemmhalter 4 gebildet. Man erkennt, dass im Klemmverbund 8 das Bauelement 2 zwischen dem Stützelement 33 und dem Klemmhalter 4 eingefügt ist.

Die Leiterplatte 6 weist zwei Durchgriffsausnehmungen 64 auf, wobei jeweils eine Durchgriffsausnehmung 64 dem zugehörigen Klemmverbund 8 zugeordnet ist.

Die zu dem Klemmverbund 8 zugehörigen Klemmflächen 71, 72 bilden ein Klemmflächenpaar, das den Klemmverbund 8 im Klemmsitz zwischen diesen Klemmflächen 71, 72 herstellt. Die erste Klemmfläche 71 erstreckt sich vor und zumindest im Wesentlichen parallel zu einer ersten Leiterplatten-Flächenseite 61, die von dem Bauelement 2 bzw. dem Kühlelement 3 abgewandt ist. Die andere zweite Flächenseite 62 der Leiterplatte 6, die mit der ersten Flächenseite 61 planparallel ist, ist dem Bauelement 2 bzw. dem vor dieser zweiten Flächenseite 62 angeordneten Stützelement 33 des Kühlelements 3 zugewandt. Die zweite Klemmfläche 72 erstreckt sich vor der zweiten Flächenseite 62 und ist zu dieser zumindest im Wesentlichen parallel. Eine Klemmeinrichtung mit einem oder mehreren parallelen Paaren paralleler erster und zweiter Klemmflächen ist nicht auf das Ausführungsbeispiel beschränkt.

Aus der zuvor beschriebenen Anordnung geht hervor, dass die Kopfseite des Klemmverbundes 8 mit einem Kopfteil durch die Durchgriffsausnehmung 64 hindurchgreift, um die Anordnung des Klemmverbundes 8 zwischen den beiden Klemmflächen 71, 72 zu erhalten. Der Klemmhalter 4 bildet eine Kopffläche 81 des Klemmverbunds 8, die nahezu oder formschlüssig, jedoch gegebenenfalls nur mit gegenüber der Klemmkraft des Klemmverbunds 8 geringfügiger Kraft an der zweiten Flächenseite 62 zur Anlage kommt. Ein Vorsprung 810 an der Kopffläche 81, der den genannten Kopfteil des Klemmverbunds 8 bildet, fasst frei durch die Durchgriffsausnehmung 64 hindurch und liegt unter Klemmspannung an der ersten Klemmfläche 71 an. Obgleich der beschriebene Klemmverbund 8 mit dem Klemmhalter 4 besondere Vorteile aufweist, kann allgemein jeder Klemmverbund aus Kühlelement und elektronischem Bauelement, auch zweiteilig ohne Klemmhalter 4, vorgesehen werden. Auch der Klemmhalter 4 ist nicht auf die beschriebene Ausbildung beschränkt. Gegebenenfalls kann er auch mehrteilig sein. Ferner können an der Klemmplatte 70 bzw. den Klemmflächen 71 Erhebungen ausgebildet oder Vorsprünge angeordnet sein, die anstelle der Vorsprünge 81 durch die Durchgriffsausnehmungen hindurchgreifen.

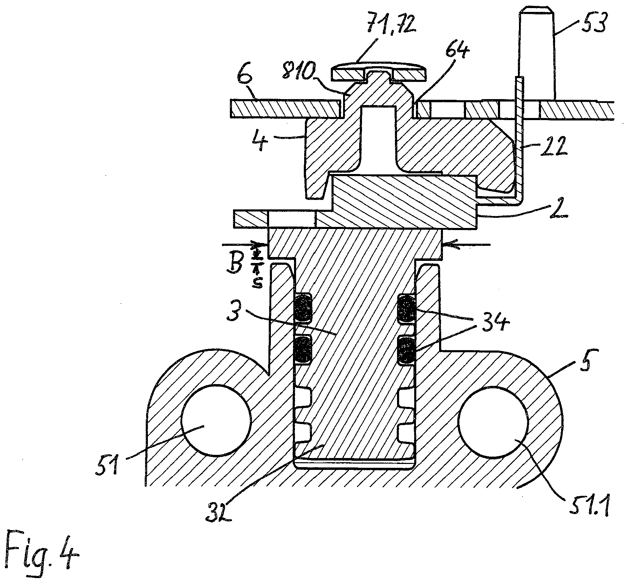

Im Ausführungsbeispiel ist die zweite Klemmfläche 72 eine passive Klemmfläche derart, dass sie für das Stützelement 33 ein festes, in den Lagerkörper 5 eingearbeitetes Widerlager bildet. In dem Lagerkörper 5 ist ein der T-förmigen Umfangskontur des Kühlelements 3 entsprechender Raum ausgebildet, in den das Kühlelement 3 eingesetzt ist. Dies geht im Detail aus der Ansicht in Fig. 4 hervor. Das Kühlelement 3 weist eine Kopfbreite B auf, die kleiner ist als die lichte Weite zwischen zwei einander gegenüberliegenden Rändern 521, die eine Einfassung zur Aufnahme des T-Kopfes des Stützelements 33 bilden. Der dem Kühlfuß 32 angepasste Raum in dem Lagerkörper 5 bildet einen Schacht 52, in dem sich der Kühlfuß 32 im Dichtsitz befindet. Der Dichtsitz ist durch in Umfangsnuten am Kühlfuß 32 eingelegte Dichtringe 34 hergestellt. Das Kühlelement 3 lässt sich vor Anbringung des Bauelements 2 und des Klemmhalters 4 einfach montieren, indem das Kühlelement 3 in einer gegenüber der dargestellten Halteposition um 90° um seine Fußachse gedrehten Position eingesetzt und dann in die Halteposition gedreht wird.

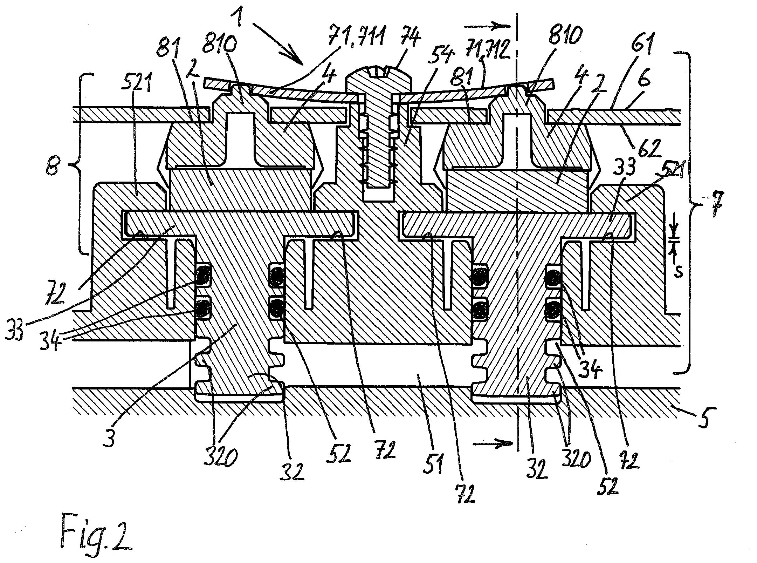

Im Ausführungsbeispiel sind die beiden Klemmflächen 71 gleiche Teile der Klemmplatte 70. Sie bilden Klemmarme 711, 712, die jeweils ein mittels der Schraubverbindung 73 federelastisches, spannspares Klemmelement bilden. Wie insbesondere aus Fig. 1 und 2 ersichtlich, weist die Leiterplatte 6 mittig zwischen den beiden Klemmverbund-Anordnungen eine Ausnehmung 65 auf. Ein hervorstehendes domartiges Sockelelement 54 des Lagerkörpers 5 fasst mit einem äußeren zurückspringenden Rand durch die Ausnehmung 65 hindurch und weist eine Innenbohrung einer Schraubverbindung 73 auf. Eine mit ihrem Kopfhals an der Klemmplatte 70 angreifende Kopfschraube 74 ist in die Innenbohrung eingedreht. Es ist eine Spanneinrichtung gebildet, mit der sich die Spann-/Klemmkraft über die federelastischen Platten-Klemmarme 711, 712 in definiertem Maß je nach Anzug der Kopfschraube gezielt einstellen lässt. Mittels der Schraubverbindung 73 wirken die Klemmflächen 71 als aktive Klemmflächen. Erfindungsgemäße Kühleinrichtungen können auch aktiv mit Spannkraft beaufschlagbare zweite Klemmflächen zusätzlich zu aktiven oder in Kombination mit passiven (festen) ersten Klemmflächen aufweisen. Weiterhin kann jedem Klemmverbund 8 ein separates Spannmittels zugeordnet werden.

Im Ausführungsbeispiel weist der vorzugsweise aus Kunststoff geformte Klemmhalter 4 eine kappenartige Form mit Formrändern 42 auf. Zwischen den Formrändern 42 ist ein Sitz für das Bauelement 2 ausgebildet, der dergestalt ist, dass auch Bauelemente 2 mit unterschiedlicher Gehäusedimension, insbesondere solche mit Toleranzabweichungen der Bauform aufgenommen werden können. Insbesondere der Auswirkung von Toleranzabweichungen kann zum Herstellen einer dennoch in jedem Fall zuverlässigen und stabilen Kühlverbindung durch Einstellung der Spann-Klemmkraft begegnet werden. Der eine Formrand 42 bildet einen Rand, an dem die Anschlusspins 22 unter Ausbildung definierte Abknicklänge und Ausrichtung zu Anschlussstellen 63 der Leiterplatte 6 abgebogen sind. Üblicherweise sind die Anschlusspins 22 in Lötverbindung an zugeordneten Anschlussstellen 63 der Leiterplatte 6 verbunden. Allgemein ist es nicht erforderlich, dass der Klemmhalter mit einer besonderen Sitzausnehmung für das elektrische Bauelement 2 geformt wird.

Im Ausführungsbeispiel bleibt die Leiterplatte 6 im Bereich, das heißt in der Umgebung der Bauelemente 2 und deren Anschlusspins 22 frei von mechanischer Befestigung an dem Lagerkörper 5. Die nur im Ausschnitt dargestellte Lagerplatte 6 ist an von dem Anordnungsbereich der Kühleinrichtung 1 entfernt gelegenen Stellen, vorzugsweise mittels nicht dargestellter Dreipunkt-Lagerung an dem Lagerkörper 5 befestigt. Man erreicht mit diesen Maßnahmen besondere Vorteile zur Montage der Bauelemente 2 insbesondere in Verbindung mit den Klemmhaltern 4. Toleranzen oder auch größeren Unterschieden der Dimensionen der Bauelemente 2 kann entsprochen werden. Gegebenenfalls kann die Leiterplatte 6 durch den Klemmhalter 4 minimal in Richtung der Klemmfläche 71 verdrängt werden, um ein Bauelement 2 aufzunehmen, dessen Bauhöhe zwischen den Klemmflächen 71, 72 geringfügig größer ist als die eines anderen, die Plattenverdrängung vermeidenden Bauelements. Wesentlich bleibt, dass die Spannkraft zum Herstellen des Kühl-Klemmverbunds 8 im Wesentlichen zwischen den Klemmflächen 71, 72 aufgebracht wird. Die Leiterplatte 6 kann, wie im Ausführungsbeispiel, an dem zurückspringenden Rand des Sockelelements 54 formschlüssig zur Stützung anliegen und gegebenenfalls mittels des Sockelelements 54 zur Montage oder bei geringfügigem Abheben geführt sein. Zu diesem Zweck ist auch ein an dem Lagerkörper 5 hervorragender Führungsstift 53 vorgesehen, der senkrecht zu den Flächen der Leiterplatte 6 gerichtet ist. Die senkrechte Führung ist auf das Ausführungsbeispiel nicht beschränkt.

In Fig. 1 bis 4 ist die Kühleinrichtung 1 Bestandteil eines nicht näher dargestellten elektronisch gesteuerten Durchlauferhitzers mit elektrischer Heizeinrichtung zum Erwärmen von durch den Durchlauferhitzer fließendem Wasser. Der Lagerkörper 5 bildet einen Montage-Grundkörper, der mit wesentlichen Teilen und Funktionsbereichen des Durchlauferhitzers ausgestattet ist. Es handelt sich im Ausführungsbeispiel um einen Durchlauferhitzer mit einer Heizeinrichtung, die zum Beispiel durch eine Blankdraht-Heizkartusche gebildet ist. Der nicht dargestellten Heizeinrichtung bzw. Heizkartusche kann durch einen (nicht dargestellten) Zulaufstutzen des Durchlauferhitzers unter Druck eingespeistes Wasser über Wasserkanäle 51.1 und 51.2 zugeführt werden. Wie aus Fig. 1 und 4 hervorgeht, sind die die Kühlrippen 320 aufweisenden Kühlfüße 32 der Kühlelemente 3 in dem Kaltwasser-Kanal 51.2, sich darin quer erstreckend, angeordnet. In dem besonderen Ausführungsbeispiel ist die Anordnung der Kühlelemente 3 derart, dass die Stützelemente 33 in den zugehörigen T-Kopf Lagerausnehmungen mit geringstem Spiel s, zum Beispiel in der Größenordnung von 1/10 mm, in Richtung der ersten Klemmflächen 71 frei und ausweichlich sind. Man erreicht dadurch, dass die Kühlelemente 3 unter Druckbeaufschlagung mit Wasser innerhalb des Kanals 51.2 in Richtung auf die ersten Klemmflächen 71 eine zusätzliche Klemmkraft jeweils auf den Klemmverbund 8 aufbringen können. In dieser Anordnung und Gestaltung wird das Stützelement 33 gegen Wasserdruck gegebenenfalls geringfügig von der zweiten Klemmfläche 72 abgehoben, wie in den Figuren dargestellt. Flächen des Kühlfußes 32, im Ausführungsbeispiel der radialen Kühlrippen 320, wirken zusätzlich als Klemm- bzw. Stützflächen zur Klemmung.

Die Klemmspannung der Klemmplatte 70 und die Klemmspannung der druckbeaufschlagten Kühlelemente 3 kann genau aufeinander abgestimmt werden. Beim Einleiten von Wasser in den Durchlauferhitzer steht das Wasser in den Kanälen 51.1, 51.2 unter Wasserleitungsdruck. Der Wasserfluss bewirkt das Schalten der elektronischen Bausteine 2, nämlich der Triac-Leistungsschalter, so dass die Heizeinrichtung durch Bestromen eines Heizelements, z.B. der Blankdraht-Heizkartusche, in Betrieb gesetzt wird. Der dadurch bedingten Erwärmung der elektronischen Bauelemente 2 wird durch besonders wirksame und zuverlässige Kühlung begegnet, indem die druckbeaufschlagten Kühlelemente 3 eine besonders verstärkte Anpressung von Wärmeleitflächen und Kühlflächen jeweils in dem Klemmverbund 8 bewirken. Die zusätzlichen druckbeaufschlagten Kühlfüße 32 können in jedem Warmwassergerät mit zu kühlenden elektronischen Bauelementen zum Einsatz kommen. Die Erfindung ist jedoch nicht auf die Nutzung der zusätzlich aktiv druckbeaufschlagten Kühlfüße 32 beschränkt. Anstelle der Kühlelemente 3 des Ausführungsbeispiels, insbesondere auch in elektrischen Warmwassergeräten/Durchlauferhitzern, können sämtliche zur thermischen Wärmeabfuhr geeignete Kühlelemente vorgesehen werden, z.B. insbesondere auch Luftkühlungselemente und/oder Kühlelemente, die Wärme thermisch an andere Elemente abgeben.

## Patentansprüche

1. Kühleinrichtung (1) eines elektronischen, sich erwärmenden Bauelements (2), umfassend das eine Wärmeleitfläche (21) zur Wärmeabführung sowie elektrische Anschlusspins (22) aufweisende elektronische Bauelement (2), eine zwei einander gegenüberliegende Flächenseiten (61, 62) aufweisende elektrische Leiterplatte (6) mit Anschlussstellen (63), mit denen die elektrischen Anschlusspins (22) verbunden sind, ein thermisches Kühlelement (3) mit einer Kühlfläche (31), die an der Wärmeleitfläche (21) anliegt, und einen Lagerkörper (5), an dem die Leiterplatte (6) gelagert ist, wobei die Kühleinrichtung (1) eine Klemmeinrichtung (7) mit einander zugewandten, an dem Lagerkörper (5) angeordneten Klemmflächen (71, 72) aufweist, wobei wenigstens eine erste Klemmfläche (71) vor der einen ersten Flächenseite (61) der Leiterplatte (6) und wenigstens eine zweite Klemmfläche (72) vor der anderen zweiten Flächenseite (62) der Leiterplatte (6) derart angeordnet sind, dass sich die Leiterplatte (6) zwischen den Klemmflächen (71, 72) erstreckt, wobei das Kühlelement (3) und das elektronische Bauelement (2) im Klemmverbund (8) mit aneinander liegender Kühlfläche (31) und Wärmeleitfläche (21) zwischen der ersten Klemmfläche (71) und der zweiten zugehörigen Klemmfläche (72) klemmend eingefügt sind, wobei die Leiterplatte (6) eine einen räumlichen Durchgriff für den Klemmverbund (8) bildende Durchgriffsausnehmung (64) aufweist und wobei der Klemmverbund (8) eine der Durchgriffsausnehmung (64) sowie der ersten Klemmfläche (71) zugeordnete Kopfseite und eine der zweiten Klemmfläche (72) zugeordnete, wenigstens durch einen Teil des Kühlelements (3) gebildete Fußseite umfasst, wobei das Kühlelement (3) einen zur Wärmeabgabe an Flüssigkeit ausgebildeten, in diese eintauchbaren Kühlfuß (32) sowie ein Stützelement (33) zur Klemmanlage gegen die zweite Klemmfläche (72) aufweist.

2. Kühleinrichtung nach Anspruch 1, **dadurch gekennzeichnet, dass** der Klemmverbund (8) durch das Kühlelement (3), einen Klemmhalter (4) und, in Klemmanordnung zwischen dem Kühlelement (3) und dem Klemmhalter (4), das elektronische Bauelement (2) gebildet ist.

3. Kühleinrichtung nach Anspruch 2, **dadurch gekennzeichnet, dass** der Klemmhalter (4) an der Kopfseite des Klemmverbunds (8) eine der ersten Klemmfläche (71) zugewandte Kopffläche (81) aufweist, an der wenigstens ein an der Kopffläche (81) hervorstehender, die Durchgriffsausnehmung (64) durchgreifender, in Klemmanlage an der ersten Klemmfläche (71) befindlicher Vorsprung (810) ausgebildet ist.

4. Kühleinrichtung nach Anspruch 2 oder 3, **dadurch gekennzeichnet, dass** der Klemmhalter (4) einen den Anschlusspins (22) zugeordneten Formrand (42) aufweist, an dem die Anschlusspins (22) unter Ausbildung definierter Abknicklänge und Ausrichtung zu den Anschlussstellen (63) der Leiterplatte (6) abgebogen sind.

5. Kühleinrichtung nach einem der Ansprüche 2 bis 4, **dadurch gekennzeichnet, dass** der Klemmhalter (4) zwischen der Leiterplatte (6) und den an den Anschlussstellen (63) der Leiterplatte (6) befestigten Anschlusspins (22) gefangen gehalten ist.

6. Kühleinrichtung nach einem der Ansprüche 2 bis 5, **dadurch gekennzeichnet, dass** der Klemmhalter (4) so ausgebildet ist, dass sich wenigstens zwei elektronische Bauelemente (2) jeweils im Klemmverbund (8) mit dem Klemmhalter (4) befinden.

7. Kühleinrichtung nach einem der Ansprüche 1 bis 6, **dadurch gekennzeichnet, dass** die Leiterplatte (6) eine Ausnehmung (65) aufweist, durch die wenigstens ein Verbindungselement hindurchfasst, das die erste Klemmfläche (71) mit dem Lagerkörper (5) verbindet.

8. Kühleinrichtung nach Anspruch 7, **dadurch gekennzeichnet, dass** das wenigstens eine Verbindungselement Bestandteil einer Schraubverbindung (73) ist.

9. Kühleinrichtung nach einem der Ansprüche 1 bis 8, **dadurch gekennzeichnet, dass** die erste Klemmfläche (71) durch einen Klemmarm (711, 712) gebildet ist.

10. Kühleinrichtung nach einem der Ansprüche 1 bis 9, **dadurch gekennzeichnet, dass** mehrere erste Klemmflächen (71) durch wenigstens zwei Klemmarme (711, 712) gebildet sind, die mittels gemeinsamer Verbindung (73) an dem Lagerkörper (5) befestigt sind.

11. Kühleinrichtung nach Anspruch 1 bis 10, **dadurch gekennzeichnet, dass** der Lagerkörper (5) einen zum Führen von unter Druck stehender Flüssigkeit eingerichteten Flüssigkeitskanal (51) und einen in den Flüssigkeitskanal (51) mündenden Schacht (52) umfasst, der den Kühlfuß (32) im gegen Flüssigkeitsdurchtritt gedichteten Sitz aufnimmt, wobei ein zur Wärmeabgabe ausgebildetes Fußende des Kühlfußes (32) in den Flüssigkeitskanal (51) hineinragt, und dass das Kühlelement (3) bei klemmender Anlageposition an der zweiten Klemmfläche (72) zur Übertragung von zusätzlicher Klemmkraft frei gehalten ist.

12. Kühleinrichtung nach einem der Ansprüche 1 bis 11, **dadurch gekennzeichnet, dass** die Leiterplatte (6) im Anordnungsbereich des elektronischen Bauelements (2) von mechanischer Befestigung mit dem Lagerkörper (5) frei ist.

13. Kühleinrichtung nach Anspruch 12, **dadurch gekennzeichnet, dass** der Lagerkörper (5) in dem Anordnungsbereich des elektronischen Bauelements (2) wenigstens ein Führungselement (53) zur zumindest im Wesentlichen mit ihren Flächenseiten (61, 62) flächenparallelen Führungspositionierung der Leiterplatte (6) aufweist.

14. Durchlauferhitzer mit elektrischer Heizeinrichtung zum Erwärmen von durch den Durchlauferhitzer fließendem Wasser, wobei die Heizeinrichtung wenigstens ein zu kühlendes elektronisches Bauelement als zum Regeln der Warmwassertemperatur ansteuerbarer Leistungsschalter sowie eine Kühleinrichtung (1) zum Kühlen des Leistungsschalters umfasst, wobei die Kühleinrichtung (1) in thermischer Verbindung mit wenigstens einer Wärmeleitfläche (21) des Leistungsschalters stehende Kühlelemente (3) aufweist, die Wärme an zu erwärmendes Wasser abgeben, **dadurch gekennzeichnet, dass** die Kühleinrichtung (1) durch eine Kühleinrichtung (1) nach einem der Ansprüche 1 bis 13 gebildet ist.

## Claims

1. Cooling device (1) of an electronic self-heating component (2), comprising the electronic component (2) with a heat conducting surface (21) to dissipate heat and electrical connection pins (22), an electrical circuit board (6) having two mutually opposite surface sides (61, 62) with connection points (63) which are connected to the electrical connection pins (22), a thermal cooling element (3) with a cooling surface (31) which lies against the heat conducting surface (21), and a bearing body (5) on which the circuit board (6) is mounted, wherein the cooling device (1) comprises a clamping device (7) with mutually facing clamping surfaces (71, 72) arranged on the bearing body (5), wherein at least one first clamping surface (71) is arranged in front of the one first surface side (61) of the circuit board (6), and at least one second clamping surface (72) is arranged in front of the other second surface side (62) of the circuit board (6) such that the circuit board (6) extends between the clamping surfaces (71, 72), wherein the cooling element (3) and the electronic component (2), with mutually contacting cooling surface (31) and heat conducting surface (21) in clamp assembly (8), are inserted clamped between the first clamping surface (71) and the second associated clamping surface (72), wherein the circuit board (6) has a penetration recess (64) forming a spatial passage for the clamp connection (8), and wherein the clamp connection (8) comprises a head side assigned to the penetration recess (64) and to the first clamping surface (71), and a foot side assigned to the second clamping surface (72) and formed at least by part of the cooling element (3), wherein the cooling element (3) has a cooling foot (32) configured to emit heat to liquid in which it can be immersed, and a support element (33) for clamping abutment against the second clamping surface (72).

2. Cooling device according to claim 1, **characterized in that** the clamp connection (8) is formed by the cooling element (3), a clamp holder (4) and the electronic component (2) held in a clamping arrangement between the cooling element (3) and the clamp holder (4).

3. Cooling device according to claim 2, **characterized in that** on the head side of the clamp connection (8), the clamp holder (4) has a head face (81) which faces the first clamping surface (71) and on which at least one protrusion (810) is formed which protrudes from the head surface (81), passes through the penetration recess (64) in clamping abutment on the first clamping surface (71).

4. Cooling device according to claim 2 or 3, **characterized in that** the clamp holder (4) has a shaped edge (42) which is assigned to the connection pins (22) and at which the connection pins (22) are bent, forming a defined kinked length and orientation to the connection points (63) of the circuit board (6).

5. Cooling device according to any of claims 2 to 4, **characterized in that** the clamp holder (4) is held captively between the circuit board (6) and the connection pins (22) attached to the connection points (63) of the circuit board (6).

6. Cooling device according to any one of claims 2 to 5, **characterized in that** the clamp holder (4) is configured such that at least two electronic components (2) are each in clamp connection (8) with the clamp holder (4).

7. Cooling device according to any one of claims 1 to 6, **characterized in that** the circuit board (6) has a recess (65) through which the at least one connecting element extends, connecting the first clamping surface (71) to the bearing body (5).

8. Cooling device according to claim 7, **characterized in that** the at least one connecting element is part of a screw connection (73).

9. Cooling device according to any one of claims 1 to 8, **characterized in that** the first clamping surface (71) is formed by a clamping arm (711, 712).

10. Cooling device according to any one of claims 1 to 9, **characterized in that** several first clamping surfaces (71) are formed by at least two clamping arms (711, 712) which are attached to the bearing body (5) by a common connection (73).

11. Cooling device according to claim 1 to 10, **characterized in that** the bearing body (5) comprises a liquid channel (51) configured to conduct pressurised liquid, and a shaft (52) which opens into the liquid channel (51) and receives the cooling foot (32) in a seat sealed against penetration of liquid, wherein a foot end of the cooling foot (32) configured to emit heat protrudes into the liquid channel (51), and **in that** the cooling element (3) is held freely to transmit additional clamping force when resting tightly against the second clamping surface (72).

12. Cooling device according to any one of claims 1 to 11, **characterized in that** the circuit board (6) is free from mechanical fixing to the bearing body (5) in the region of arrangement of the electronic component (2).

13. Cooling device according to claim 12, **characterized in that** in the region of arrangement of the electronic component (2), the bearing body (5) has at least one guide element (53) for guiding and positioning of the circuit board (6) with its surface sides (61, 62) at least substantially planar parallel.

14. Continuous-flow heater with electrical heating device for heating water flowing through the continuous-flow heater, wherein the heating device comprises at least one electronic component to be cooled, as a power switch which can be activated to control the warm water temperature, and a cooling device (1) for cooling the power switch, wherein the cooling device (1) has cooling elements (3) which are in thermal connection with at least one heat conducting surface (21) of the power switch and emit heat to the water to be heated, **characterized in that** the cooling device (1) is formed by a cooling device (1) according to any one of claims 1 to 13.

## Revendications

1. Dispositif de refroidissement (1) d'un composant électronique subissant un réchauffement (2), comprenant une surface thermoconductrice (21) de dissipation thermique ainsi que des composants électroniques (2) munis de broches de raccordement électriques (22), un circuit imprimé (6) électrique comprenant deux surfaces opposées (61, 62) et muni de points de raccordement (63), auxquels les broches de raccordement électriques (22) sont connectées, un élément de refroidissement thermique (3) avec surface refroidissant (31), placée contre la surface thermoconductrice (21), et un élément de support (5), contre lequel le circuit imprimé (6) repose, dans lequel le dispositif de refroidissement (1) comprend un dispositif de serrage (7) avec des surfaces de serrage (71, 72) disposées sur l'élément de support (5) et se faisant face, dans lequel au moins une des premières surfaces de serrage (71) est placée devant la première surface (61) du circuit imprimé (6) et au moins une second surface de serrage (72) est placée devant la seconde surface (62) du circuit imprimé (6) de façon à ce que le circuit imprimé (6) s'étende entre les surfaces de serrage (71, 72), dans lequel l'élément de refroidissement (3) et le composant électronique (2) sont insérés dans la combinaison de serrage (8) entre la première surface de serrage (71) et la seconde surface de serrage correspondante (72), la surface refroidissante (31) et la surface thermoconductrice (21) reposant l'un contre l'autre, dans lequel le circuit imprimé (6) comporte une cavité de passage (64) constituant une ouverture physique de passage pour la combinaison de serrage (8) et dans lequel la combinaison de serrage (8) englobe l'une des cavités de passage (64) ainsi que la partie supérieure associée à la première surface de serrage (71) et la partie inférieure constituée par au moins une partie de l'élément de refroidissement (3) associée à la deuxième surface de de serrage (72), dans lequel l'élément de refroidissement (3) comprend un pied de refroidissement (32) immergeable conçu pour l'échange de chaleur dans des liquides, ainsi qu'un élément d'appui (33) servant de dispositif de serrage contre la seconde surface de serrage (72).

2. Dispositif de refroidissement selon la revendication 1, **caractérisé en ce que** la combinaison de serrage (8) est constituée de l'élément de refroidissement (3), d'un support de serrage (4) et du composant électronique (2) agencé entre l'élément de refroidissement (3) et le support de serrage (4).

3. Dispositif de refroidissement selon la revendication 2, **caractérisé en ce que** le support de serrage (4) comprend une surface supérieure (81) associée à la première surface de serrage (71) du côté supérieur de la combinaison de serrage (8), dans laquelle se trouve au moins une saillie (810) dans la surface de serrage (71) de la combinaison de serrage dépassant de la surface supérieure (81), et traversant la cavité de passage (64).

4. Dispositif de refroidissement selon la revendication 2 ou 3, **caractérisé en ce que** le support de serrage (4) dispose d'un rebord (42) associé aux broches de raccordement (22) sur lequel les broches de raccordement (22) sont pliées en produisant une longueur de pliage définie et en les orientant en direction des points de raccordement (63) du circuit imprimé (6).

5. Dispositif de refroidissement selon l'une des revendications 2 à 4, **caractérisé en ce que** le support de serrage (4) est maintenu en place entre le circuit imprimé (6) et les broches de raccordement (22) connectées aux points de raccordement (63) du circuit imprimé (6).

6. Dispositif de refroidissement selon l'une des revendications 2 à 5, **caractérisé en ce que** le support de serrage (4) est conçu de façon à ce qu'il se trouve au moins deux composants électroniques (2) respectivement dans la combinaison de serrage (8) comprenant le support de serrage (4).

7. Dispositif de refroidissement selon l'une des revendications 1 à 6, **caractérisé en ce que** le circuit imprimé (6) comprend un évidement (65) traversé par au moins un élément de raccordement, reliant la première surface de serrage (71) à l'élément de support (5).

8. Dispositif de refroidissement selon la revendication 7, **caractérisé en ce que** le ou les éléments de raccordement fait partie d'un assemblage vissé (73).

9. Dispositif de refroidissement selon l'une des revendications 1 à 8, **caractérisé en ce que** la première surface de serrage (71) est constituée d'un bras de serrage (711, 712).

10. Dispositif de refroidissement selon l'une des revendications 1 à 9, **caractérisé en ce que** plusieurs premières surfaces de serrage (71) sont constituées d'au moins deux bras de serrage (711, 712) fixés à l'élément de support (5) par un assemblage commun (73).

11. Dispositif de refroidissement selon la revendication 1 à 10, **caractérisé en ce que** l'élément de support (5) comprend un canal d'écoulement des liquides (51) conçu pour assurer l'écoulement des liquides sous pressions et une cavité (52) donnant sur le canal d'écoulement des liquides (51) permettant d'héberger le pied de refroidissement (32) dans un siège étanchéifié contre le passage des liquides, dans lequel une extrémité du pied de refroidissement (32) conçue pour assurer l'échange de chaleur plonge dans le canal d'écoulement des liquides (51), et **en ce que** l'élément de refroidissement (3) reste libre pour pouvoir assurer la transmission de forces de serrage supplémentaires en cas de position serrée au niveau de la deuxième surface de serrage (72).

12. Dispositif de refroidissement selon l'une des revendications 1 à 11, **caractérisé en ce que** le circuit imprimé (6) est dépourvu de fixation mécanique à l'élément de support (5) dans la zone de positionnement du composant électronique (2).

13. Dispositif de refroidissement selon la revendication 12, **caractérisé en ce que** l'élément de support (5) comprend au moins un élément de guidage (53) permettant d'assurer au moins dans l'ensemble une position de guidage parallèle à sa surface (61, 62) du circuit imprimé (6) dans la zone de positionnement du composant électronique (2).

14. Chauffe-eau instantané avec un dispositif de chauffage électrique pour le chauffage de l'eau s'écoulant dans le chauffe-eau instantané, dans lequel le dispositif de chauffage comprend au moins un commutateur de puissance pouvant être commandé pour assurer le refroidissement des composants électroniques et la régulation de la température de l'eau chaude ainsi qu'un dispositif de refroidissement (1) assurant le refroidissement du commutateur de puissance, et dans lequel le dispositif de refroidissement (1) comprend des éléments de refroidissement (3) établissant un contact thermique avec au moins l'une des surfaces thermoconductrices (21) du commutateur de puissance, transmettant la chaleur à l'eau devant être chauffée, **caractérisé en ce que** le dispositif de refroidissement est constitué d'un dispositif de refroidissement (1) selon l'une des revendications 1 à 13.
